# EUROPÄISCHE PATENTSCHRIFT

(11) **EP 2 148 899 B1**
(45) Veröffentlichungstag und Bekanntmachung des Hinweises auf die Patenterteilung: **28.07.2010**
(21) Anmeldenummer: 08716213.7
(22) Anmeldetag: 04.03.2008
(51) Int. Cl.: C08J 5/18, C23C 14/08, C23C 16/40

(54) **TRANSPARENTE BARRIEREFOLIE UND VERFAHREN ZUM HERSTELLEN DERSELBEN**
TRANSPARENT BARRIER FILM AND METHOD FOR PRODUCING THE SAME
FEUILLE BARRIÈRE TRANSPARENTE ET PROCÉDÉ POUR SA FABRICATION

(30) Priorität: 27.04.2007 DE 102007019994
(43) Veröffentlichungstag der Anmeldung: 03.02.2010
(73) Patentinhaber: Fraunhofer-Gesellschaft zur Förderung der angewandten Forschung e.V., 80686 München (DE)
(72) Erfinder: FAHLAND, Matthias, 01259 Dresden (DE); VOGT, Tobias, 02796 Kurort Johnsdorf (DE); SCHILLER, Nicolas, 01833 Stolpen/Helmsdorf (DE); FAHLTEICH, John,, 01279 Dresden (DE); SCHÖNBERGER, Waldemar, 01109 Dresden (DE)
(86) Internationale Anmeldenummer: PCT/EP2008/001694
(87) Internationale Veröffentlichungsnummer: WO 2008/135109

(56) Entgegenhaltungen:
- EP-A- 0 636 702
- EP-A- 1 115 670
- EP-A- 1 439 241
- EP-A- 1 609 816
- WO-A-2005/073427

## Beschreibung

Die Erfindung betrifft eine thermoplastische Barrierefolie mit einer ausgezeichneten Permeationssperre gegenüber Sauerstoff und Wasserdampf bei gleichzeitig hoher Transparenz für Licht im sichtbaren Spektralbereich. Die Erfindung betrifft weiterhin ein Verfahren zum Herstellen einer solchen Folie.

### Stand der Technik

Der Einsatz von Kunststofffolien als Verpackungsmaterial oder als Schutzfilm für empfindliche Gegenstände ist sehr weit verbreitet. Häufig besteht die Forderung, dass diese Kunststofffolien nicht nur einen mechanischen Schutz oder eine mechanische Eingrenzung bieten müssen, sondern gleichzeitig sollen diese Folien auch eine Sperrwirkung gegenüber Gasen erzielen. Diese Sperrwirkung wird im Weiteren auch Permeationssperre genannt. Bei der Sperrwirkung von Barrierefolien ist oftmals von besonderem Interesse, dass diese Sperrwirkung gegenüber den in der Atmosphäre enthaltenen Gasen Sauerstoff und Wasserdampf erzielt wird. Diese Gase können im Kontakt mit Gegenständen vielfältige chemische Reaktionen bewirken, die in Bezug auf ein zu schützendes Material häufig unerwünscht sind. Weit verbreitet ist die Anwendung von Barrierefolien bei der Verpackung von Lebensmitteln. Als Merkmal für die Güte einer Permeationssperre ist die Größe Wasserdampftransmissionsrate bekannt. Eine Folie aus Polyethylenterephtalat (PET) besitzt beispielsweise bei einer Dicke von 125 µm eine Wasserdampftransmissionsrate von etwa 8 g/m²d (wobei das "d" in der Einheitsangabe für "day" also für 24 Stunden steht). Dieser Wert ist abhängig von der Dicke der Folie. Bei vielen Anwendungen werden jedoch noch deutlich niedrigere Permeationswerte gefordert. Beispielsweise ist es notwendig, für Lebensmittelverpackungen einen Wert von etwa 1 g/m²d zu erreichen.

Es ist bekannt, dass man solche Werte dann erzielen kann, wenn eine mehrlagige Barrierefolie verwendet wird. Eine Lage ist hierbei die Kunststofffolie selbst, eine zweite Lage wird beispielsweise durch eine dünne Schicht auf der Folie realisiert, welche eine höhere Permeationswirkung erzielt. Eine derartige Schicht kann beispielsweise aus Aluminium sein. Oftmals besteht eine Anforderung darin, dass eine Barrierefolie nicht nur eine Permeationssperre aufweisen, sondern zugleich auch noch transparent sein soll. Unter Transparenz wird hierbei verstanden, dass diese Folie im sichtbaren Spektralbereich, das heißt zwischen 380 nm und 780 nm Lichtwellenlänge, eine Transmission von wenigstens 70 % aufweist. Die Forderung nach Transparenz besteht insbesondere dann, wenn eine Barrierefolie für die Verkapselung von optoelektronischen Geräten wie Solarzellen oder Anzeigeelementen verwendet werden soll. Bei einer solchen Anforderung ist die Kombination von einer Kunststofffolie mit einer dünnen Metallschicht ungeeignet.

Es ist bekannt, dass durch eine Kombination von einer Kunststofffolie mit einer Oxidschicht eine Wasserdampftransmissionsrate von etwa 1 g/m²d und darunter erreicht werden kann, wobei der exakte Wert sowohl von dem verwendeten Beschichtungsverfahren als auch vom Beschichtungsmaterial abhängig ist, denn die Oxide verschiedener Elemente sind nicht gleichermaßen für Schichten mit Permeationswirkung geeignet. So ist beispielsweise bekannt, dass mit TiO₂-Schichten keine gute Sperrwirkung erzielt werden kann, wohingegen Oxid-Schichten des Elements Aluminium eine sehr gute Permeationssperre ausbilden *(*N. Schiller et al., Barrier Coatings on Plastic Web, 44th Annual Technical Conference Proceedings. 2001*).* Weiterhin weisen auch Schichten aus Si₃N₄ eine sehr gute Permeationssperre auf.

Die Materialien Si₃N₄ und Aluminiumoxid neigen jedoch nach dem Aufbringen auf flexible Kunststoffbahnen zur Rissbildung, was sich negativ auf die erreichte Sperrwirkung auswirkt. Gleichfalls wird dadurch der Gebrauch derartiger Barrierefolien eingeschränkt. Dieser Umstand wird nicht nur bei der Verpackung von Lebensmitteln zum Nachteil, sondern auch dann, wenn empfindliche technische Güter geschützt werden sollen. Derartige Güter können beispielsweise Solarzellen (Anforderung: Wasserdampftransmissionsrate 10⁻³ g/m²d), Dünnschichtbatterien auf Lithiumbasis (Anforderung: Wasserdampftransmissionsrate 2x10⁻⁴g/m²d) oder organische Leuchtdioden (Anforderung: Wasserdampftransmissionsrate 10⁻⁶ g/m²d) sein.

Wenn auch allgemein gilt, dass mit zunehmender Schichtdicke die Sperrwirkung einer Barriereschicht zunimmt, so lässt sich auf Grund der Rissbildung, insbesondere bei Aluminiumoxidschichten, ab einer bestimmten Schichtdicke keine Zunahme der Barrierewirkung mehr erzielen. So wird beispielsweise bei einer Al₂O₃-Schicht mit einer Schichtdicke von etwa 100 nm bezüglich der Barrierewirkung ein Wert von 0,09 g/m²d erreicht. Bei einer weiteren Schichtdickenzunahme ist keine merkliche Zunahme hinsichtlich der Barrierewirkung mehr zu verzeichnen.

Es sind vielfältige Verbesserungen bei bekannten Barrierefolien durchgeführt worden. Das betrifft insbesondere Sperrschichten mit erhöhter Permeationssperrwirkung. So ist beispielsweise aus EP 0 311 432 A2 eine SiO₂-Schicht mit einem Gardienten bezüglich der Materialeigenschaften bekannt. Damit soll eine mechanische Anpassung der Permeationssperre an die Kunststofffolie und damit eine bessere mechanische Widerstandsfähigkeit erreicht werden.

Ein anderer Ansatz besteht in einem mehrlagigen Aufbau eines Schichtsystems, bei dem immer abwechselnd eine anorgansiche und eine organische Schicht aufgebracht werden. Solch ein Ansatz wird in J. D. Affinito et al., Thin Solid Films 290-291 (1996), S. 63-67*,* vorgestellt, wobei Al₂O₃ als anorgansiche Schicht mit hoher Sperrwirkung verwendet wird.

In DE 10 2004 005 313 A1 wird eine anorganische Schicht mit einer zweiten Schicht kombiniert, die in einem speziellen magnetronbasierten PECVD-Verfahren aufgebracht wird. Auch in diesem Falle bildet Al₂O₃ als anorganische Schicht eine der möglichen Ausführungsformen.

All den bekannten Ansätzen ist gemeinsam, dass eine hohe Sperrwirkung erzielt wird, indem mindestens ein Material mit hoher Sperrwirkung mittels einer entsprechenden Beschichtungstechnologie auf einer Kunststofffolie abgeschieden wird. Die dabei verwendeten Materialen, insbesondere Al₂O₃, neigen jedoch zur Rissbildung bei mechanischer Beanspruchung, was deren Verwendung einschränkt.

### Aufgabenstellung

Der Erfindung liegt daher das technische Problem zugrunde eine transparente Barrierefolie und ein Verfahren zu deren Herstellung zu schaffen, mittels denen die Nachteile aus dem Stand der Technik überwunden werden können. Insbesondere soll die Barrierefolie sehr gute Sperreigenschaften gegenüber Sauerstoff und Wasserdampf aufweisen und weniger anfällig für Rissbildungen bei mechanischer Beanspruchung sein.

Die Lösung des technischen Problems ergibt sich durch die Gegenstände mit den Merkmalen der Patentansprüche 1 und 8. Weitere vorteilhafte Ausgestaltungen der Erfindung ergeben sich aus den abhängigen Patentansprüchen.

Eine erfindungsgemäße transparente Barrierefolie umfasst eine transparente thermoplastische Folie und mindestens eine Permeationssperrschicht. Dabei besteht die Permeationssperrschicht aus einer chemischen Verbindung der Elemente Zink, Zinn und Sauerstoff, wobei der Masseanteil von Zink 5 % bis 70 % beträgt.

Es wurde festgestellt, dass eine dünne Schicht aus Zink-Zinn-Oxid als amorphes Material vorliegt. Es weist damit eine geringere Packungsdichte auf als vergleichbare mikrokristalline Materialien, wie beispielsweise reines Zinkoxid. Dennoch zeichnet sich das Mischoxid einer Legierung aus Zink und Zinn durch eine sehr ausgeprägte Permeationssperrwirkung aus. Weiterhin zeigte sich überraschenderweise, dass Schichten aus Zink-Zinn-Oxid eine gegenüber Aluminiumoxid sehr stark verbesserte Flexibilität und eine geringere Neigung zur Rissbildung aufweisen. So konnte auch mit einer Zunahme der Dicke einer Zink-Zinn-OxidSchicht über 100 nm hinaus eine weitere Verbesserung der Barriereeigenschaften erzielt werden.

Eine Permeationssperrschicht einer erfindungsgemäßen Barrierefolie kann daher in einem breiten Schichtdickenbereich von 20 nm bis 1000 nm ausgebildet sein. Sehr gute Barriereeigenschaften werden aber auch schon in einem Schichtdickenbereich von 50 nm bis 300 nm erzielt.

Neben einer thermoplastischen Folie und einer Permeationssperrschicht kann eine erfindungsgemäße Barrierefolie weitere Schichten umfassen. So kann beispielsweise eine weitere Schicht, welche die Elemente Silizium und Kohlenstoff umfasst und einen Kohlenstoff-Masseanteil von 1 % bis 10 % aufweist, zwischen der Folie und der Permeationssperrschicht abgeschieden sein. Eine derartige Schicht dient einerseits als Glättungsschicht und bewirkt andererseits einen Ausgleich bzw. einen kontinuierlicheren Übergang von den mechanischen Eigenschaften der Folie und denen der Permeationssperrschicht.

Ähnliche Wirkungen können aber auch ohne eine solche Zwischenschicht erzielt werden, wenn die Permeationssperrschicht auf der Folie mit einem Gradienten derart ausgebildet wird, dass die Permeationssperrschicht auf der der Folie zugewandten Seite einen Kohlenstoff-Masseanteil von bis zu 5 % aufweist.

Bei einer weiteren Ausführungsform der Erfindung umfasst eine transparente Barrierefolie eine elektrisch leitfähige Schicht mit einem spezifischen Widerstand von weniger als 2x10⁻³ Ωcm. Eine derartige Barrierefolie mit einer solchen Funktionsschicht kann gleichzeitig als transparente Elektrode verwendet werden. Es besteht auch die Möglichkeit, dass eine erfindungsgemäße Barrierefolie einen Schichtstapel umfasst, bei welchem Permeationssperrschichten, Glättungsschichten und/oder Funktionsschichten alternierend auf einer Folie abgeschieden sind.

Bei einem erfindungsgemäßen Verfahren zum Herstellen einer transparenten Barrierefolie, umfassend eine transparente thermoplastische Folie und mindestens eine Permeationssperrschicht, wird die Permeationssperrschicht als eine chemische Verbindung der Elemente Zink, Zinn und Sauerstoff mittels eines Vakuumbeschichtungsverfahrens abgeschieden.

Dabei wird die Permeationssperrschicht mit einer Dicke von 20 nm bis 1000 nm und vorzugsweise in einem Bereich von 50 nm bis 300 nm abgeschieden.

Als Vakuumbeschichtungsverfahren ist beispielsweise das Magnetronsputtern geeignet. Hierbei wird eine Legierung aus Zink und Zinn als Target zerstäubt, wobei der Zerstäubungsprozess unter Anwesenheit des Reaktivgases Sauerstoff ausgeführt wird.

Um gleichmäßige Barriereeigenschaften auf der gesamten Oberfläche einer Folie erzielen zu können, ist es auch erforderlich, dass auf der gesamten Folienoberfläche eine Permeationssperrschicht mit gleich bleibender Schichtdicke abgeschieden wird. Die Dicke einer abgeschiedenen Permeationssperrschicht lässt sich vorteilhaft über die Zufuhr des Reaktivgases Sauerstoff in die Vakuumarbeitskammer einstellen. Bekanntlich führt eine Zunahme von Sauerstoff während eines reaktiven Sputterprozesses dazu, dass sich auf dem zu zerstäubenden Target vermehrt Reaktionsprodukte ausbilden, was wiederum zum Absenken der Sputterrate führt. Über die Zufuhr des Reaktivgases lässt sich somit der Schichtzuwachs einer Permeationssperrschicht einstellen.

Bei einer bevorzugten Ausführungsform wird deshalb der Sauerstoffeinlass in die Vakuumarbeitskammer mittels eines Regelkreises gesteuert. Hierbei ist es wiederum vorteilhaft, wenn eine Regelgröße zum Steuern des Sauerstoffeinlasses aus dem optischen Emissionsspektrum des Sputterplasmas ermittelt wird.

Als Regelgröße kann beispielsweise der Quotient aus einer Emissionslinie von Zink oder Zinn und einer Emissionslinie des verwendeten Inertgases ermittelt werden.

### Ausführungsbeispiel

Die Erfindung wird nachfolgend anhand eines bevorzugten Ausführungsbeispiels näher erläutert. Die Fig. zeigen:
- Fig. 1: eine schematische Darstellung eines Regelkreises zum Einstellen des Sauerstoff- zuflusses beim reaktiven Abscheiden einer ZnSnOₓ-Schicht durch Magnetron- Sputtern in Abhängigkeit von Werten, die aus der Intensität zweier Spektrallinien des Magnetronplasmas gewonnen werden;
- Fig. 2: eine graphische Darstellung der Abhängigkeit der Wassertransmissionsrate von der Schichtdicke einer Permeationssperrschicht aus Al₂O₃ und einer Permeations- sperrschicht aus ZnSnOₓ.

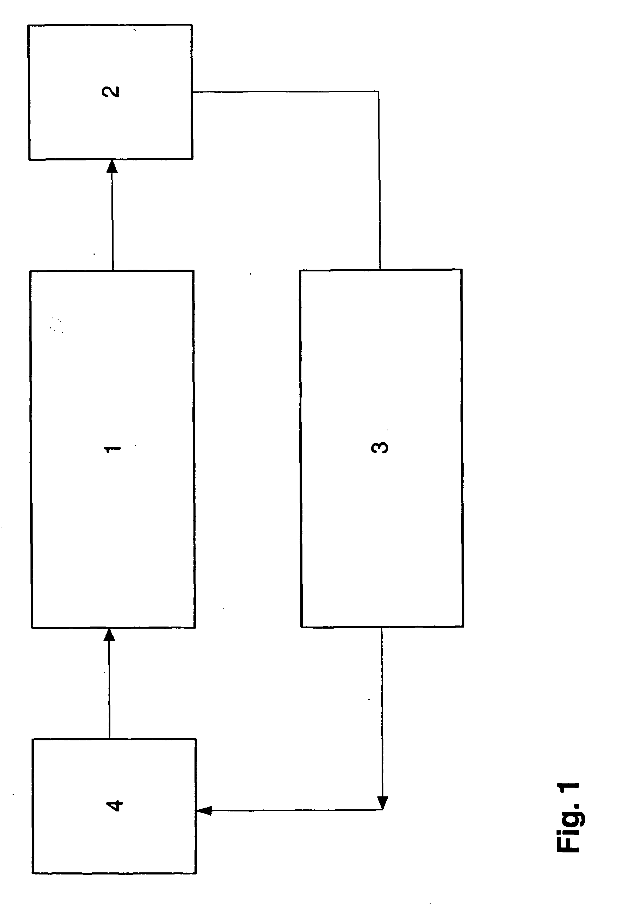

Auf einer thermoplastischen Kunststofffolie aus Polyethylenterephtalat (PET) wird mittels eines reaktiven Sputterverfahrens eine Permeationssperrschicht aus Zink-Zinn-Oxid abgeschieden. Hierfür wird ein Target aus einer Zink-Zinn-Legierung unter der Anwesenheit des Inertgases Argon und bei Zufuhr des Reaktivgases Sauerstoff zerstäubt. Es ist bekannt, dass über die Zufuhr des Reaktivgases Sauerstoff der Grad der Bedeckung des Targets mit Reaktionsprodukten und somit die Abscheiderate/Schichtdicke und die Schichtzusammensetzung einstellbar sind. In Fig. 1 ist ein Regelkreis schematisch dargestellt, mittels dem die Permeationssperrschicht mit einer gleich bleibenden Schichtdicke und dadurch mit gleich bleibenden Barriereeigenschaften abgeschieden werden kann.

In einer Vakuumkammer 1 zur Durchführung des Sputterprozesses werden mittels eines Spektrometers 2 ein Intensitätswert einer Spektrallinie von Zink und ein Intenstitätswert einer Spektrallinie von Argon erfasst, an eine Auswerteeinrichtung 3 weitergeleitet und in dieser ein Quotient aus den beiden Intensitätswerten gebildet. Aus dem Vergleich des auf diese Weise ermittelten Quotientenistwertes mit einem vorgegebenen Sollwert wird ein Stellsignal erzeugt, welches ein Sauerstoffeinlassventil 4 ansteuert und die Sauerstoffzufuhr in die Vakuumkammer 1 derart nachregelt, dass der ermittelte Quotientenistwert an den vorgegebenen Sollwert angeglichen wird.

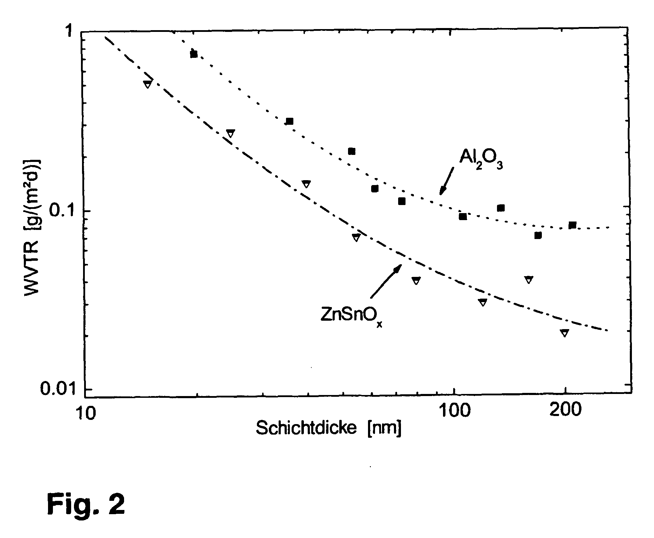

In Fig. 2 ist die Permeationssperrwirkung einer Barrierefolie mit einer Sperrschicht aus Zink-Zinn-Oxid, welche nach dem erfindungsgemäßem Verfahren abgeschieden wurde, in Abhängigkeit von der Schichtdicke der Sperrschicht graphisch dargestellt. Als Maß für die Permeationssperrwirkung ist dabei auf der Ordinatenachse die Wasserdampftransmissionsrate aufgetragen. Die jeweiligen Wertepaare bezüglich Schichtdicke und Wasserdampftransmissionsrate sind als kleine Dreiecke und eine daraus resultierende geglättete Kurve als Strich-Punkt-Linie dargestellt.

Ebenfalls dargestellt ist in Fig. 2 die Permeationssperrwirkung einer Barrierefolie mit identischem Foliensubstrat, aber einer Al₂O₃-Schicht nach dem Stand der Technik in Abhängigkeit von der Schichtdicke der Al₂O₃-Schicht. Die hierzu gehörenden Wertepaare sind als kleine Quadrate und eine daraus resultierende geglättete Kurve als Punkt-Linie dargestellt. Aus Fig. 2 ist zu erkennen, dass eine erfindungsgemäße Barrierefolie bei gleicher Dicke eine bessere Permeationssperrwirkung aufweist als eine Barrierefolie mit Al₂O₃-schicht nach dem Stand der Technik. Ebenfalls ist ersichtlich, dass ab einer Schichtdicke von etwa 100 nm bei der Al₂O₃-Schicht keine signifikante Verbesserung der Sperrwirkung erzielbar ist, wohingegen bei der erfindungsgemäßen Barrierefolie auch eine Steigerung der Schichtdicke über 100 nm hinaus noch eine signifikante Verbesserung der Barriereeigenschaften bewirkt, woraus sich wiederum ableiten lässt, dass eine erfindungsgemäße Barrierefolie weniger zur Rissbildung neigt als bekannte Barrierefolien mit Al₂O₃-Schicht.

## Patentansprüche

1. Transparente Barrierefolie, umfassend eine transparente thermoplastische Folie und mindestens eine Permeationssperrschicht, **dadurch gekennzeichnet, dass** die Permeationssperrschicht aus einer chemischen Verbindung der Elemente Zink, Zinn und Sauerstoff besteht, wobei der Masseanteil von Zink 5 % bis 70 % beträgt.

2. Barrierefolie nach Anspruch 1, **dadurch gekennzeichnet, dass** die Permeationssperrschicht mit einer Dicke von 20 nm bis 1000 nm ausgebildet ist.

3. Barrierefolie nach Anspruch 2, **dadurch gekennzeichnet, dass** die Permeationssperrschicht mit einer Dicke von 50 nm bis 300 nm ausgebildet ist.

4. Barrierefolie nach einem der vorhergehenden Ansprüche, **dadurch gekennzeichnet, dass** die Permeationssperrschicht auf der der thermoplastischen Folie zugewandten Seite einen Kohlenstoff-Masseanteil von bis zu 5 % aufweist.

5. Barrierefolie nach einem der vorhergehenden Ansprüche, **dadurch gekennzeichnet, dass** die Barrierefolie mindestens eine weitere Schicht umfasst.

6. Barrierefolie nach Anspruch 5, **dadurch gekennzeichnet, dass** eine erste weitere Schicht elektrisch leitfähig ist und einen spezifischen Widerstand von weniger als 2x10⁻³ Ωcm aufweist.

7. Barrierefolie nach Anspruch 5 oder 6, **dadurch gekennzeichnet, dass** eine zweite weitere Schicht die Elemente Silizium und Kohlenstoff umfasst, wobei der Kohlenstoff-Masseanteil 1% bis 10 % beträgt.

8. Verfahren zum Herstellen einer transparenten Barrierefolie, umfassend eine transparente thermoplastische Folie und mindestens eine Permeationssperrschicht, **dadurch gekennzeichnet, dass** die Permeationssperrschicht als eine chemische Verbindung der Elemente Zink, Zinn und Sauerstoff mittels eines Vakuumbeschichtungsverfahrens abgeschieden wird.

9. Verfahren nach Anspruch 8, **dadurch gekennzeichnet, dass** die Permeationssperrschicht mit einer Dicke von 20 nm bis 1000 nm abgeschieden wird.

10. Verfahren nach Anspruch 9, **dadurch gekennzeichnet, dass** die Permeationssperrschicht mit einer Dicke von 50 nm bis 300 nm abgeschieden wird.

11. Verfahren nach einem der Ansprüche 8 bis 10, **dadurch gekennzeichnet, dass** die Permeationssperrschicht durch Sputtern abgeschieden wird.

12. Verfahren nach Anspruch 11, **dadurch gekennzeichnet, dass** ein Target, umfassend eine Legierung aus Zink und Zinn, unter Einlass des Reaktivgases Sauerstoff zerstäubt wird.

13. Verfahren nach Anspruch 12, **dadurch gekennzeichnet, dass** der Sauerstoffeinlass mittels eines Regelkreises gesteuert wird, bei welchem eine Regelgröße aus dem optischen Emissionsspektrum des Sputterplasmas ermittelt wird.

14. Verfahren nach Anspruch 13, **dadurch gekennzeichnet, dass** als Regelgröße der Quotient aus einer Emissionslinie von Zink oder Zinn und einer Emissionslinie des verwendeten Inertgases ermittelt wird.

## Claims

1. Transparent barrier film, comprising a transparent thermoplastic film and at least one permeation barrier layer, **characterized in that** the permeation barrier layer consists of a chemical compound of the elements zinc, tin and oxygen, the proportion of zinc being 5% to 70% by mass.

2. Barrier film according to Claim 1, **characterized in that** the permeation barrier layer is formed with a thickness of 20 nm to 1000 nm.

3. Barrier film according to Claim 2, **characterized in that** the permeation barrier layer is formed with a thickness of 50 nm to 300 nm.

4. Barrier film according to one of the preceding claims, **characterized in that** the proportion of carbon on that side of the permeation barrier layer which faces the thermoplastic film is up to 5% by mass.

5. Barrier film according to one of the preceding claims, **characterized in that** the barrier film comprises at least one further layer.

6. Barrier film according to Claim 5, **characterized in that** a first further layer is electrically conductive and has a specific resistivity of less than 2 x 10⁻³ Ωcm.

7. Barrier film according to Claim 5 or 6, **characterized in that** a second further layer comprises the elements silicon and carbon, the proportion of carbon being 1% to 10% by mass.

8. Process for producing a transparent barrier film, comprising a transparent thermoplastic film and at least one permeation barrier layer, **characterized in that** the permeation barrier layer is deposited as a chemical compound of the elements zinc, tin and oxygen by means of a vacuum coating process.

9. Process according to Claim 8, **characterized in that** the permeation barrier layer is deposited with a thickness of 20 nm to 1000 nm.

10. Process according to Claim 9, **characterized in that** the permeation barrier layer is deposited with a thickness of 50 nm to 300 nm.

11. Process according to one of Claims 8 to 10, **characterized in that** the permeation barrier layer is deposited by sputtering.

12. Process according to Claim 11, **characterized in that** a target comprising an alloy of zinc and tin is sputtered with admission of oxygen as reactive gas.

13. Process according to Claim 12, **characterized in that** the admission of oxygen is controlled by means of a control circuit, in which a control variable is determined from the optical emission spectrum of the sputter plasma.

14. Process according to Claim 13, **characterized in that** the control variable determined is the quotient of an emission line of zinc or tin and an emission line of the inert gas used.

## Revendications

1. Feuille transparente formant une barrière, comprenant une feuille thermoplastique transparente et au moins une couche de blocage de la perméation, **caractérisée en ce que** la couche de blocage de la perméation est constituée par un composé chimique des éléments zinc, étain et oxygène, la proportion massique du zinc étant de 5% à 70%.

2. Feuille formant une barrière selon la revendication 1, **caractérisée en ce que** la couche de blocage de la perméation est réalisée avec une épaisseur de 20 nm à 1000 nm.

3. Feuille formant une barrière selon la revendication 2, **caractérisée en ce que** la couche de blocage de la perméation est réalisée avec une épaisseur de 50 nm à 300 nm.

4. Feuille formant une barrière selon l'une quelconque des revendications précédentes, **caractérisée en ce que** la couche de blocage de la perméation présente, sur la face orientée vers la feuille thermoplastique, une proportion massique de carbone allant jusqu'à 5%.

5. Feuille formant une barrière selon l'une quelconque des revendications précédentes, **caractérisée en ce que** la feuille formant une barrière comprend au moins une autre couche.

6. Feuille formant une barrière selon la revendication 5, **caractérisée en ce qu'**une première autre couche est électriquement conductrice et présente une résistance spécifique inférieure à 2 x 10⁻³ Ω cm.

7. Feuille formant une barrière selon la revendication 5 ou 6, **caractérisée en ce qu'**une deuxième autre couche comprend les éléments silicium et carbone, la proportion massique de carbone allant de 1% à 10%.

8. Procédé pour la fabrication d'une feuille transparente formant une barrière, comprenant une feuille thermoplastique transparente et au moins une couche de blocage de la perméation, **caractérisé en ce que** la couche de blocage de la perméation est déposée sous forme d'un composé chimique des éléments zinc, étain et oxygène au moyen d'un procédé de revêtement sous vide.

9. Procédé selon la revendication 8, **caractérisé en ce que** la couche de blocage de la perméation est déposée avec une épaisseur de 20 nm à 1000 nm.

10. Procédé selon la revendication 9, **caractérisé en ce que** la couche de blocage de la perméation est déposée avec une épaisseur de 50 nm à 300 nm.

11. Procédé selon l'une quelconque des revendications 8 à 10, **caractérisé en ce que** la couche de blocage de la perméation est déposée par pulvérisation.

12. Procédé selon la revendication 11, **caractérisé en ce qu'**une cible, comprenant un alliage de zinc et d'étain, est vaporisée avec admission du gaz réactif oxygène.

13. Procédé selon la revendication 12, **caractérisé en ce que** l'admission d'oxygène est contrôlée au moyen d'un circuit de régulation, dans lequel une grandeur de régulation est déterminée par le spectre d'émission optique du plasma de pulvérisation.

14. Procédé selon la revendication 13, **caractérisé en ce qu'**on détermine comme grandeur de régulation le quotient d'une ligne d'émission du zinc ou de l'étain et d'une ligne d'émission du gaz inerte utilisé.
